# EUROPEAN PATENT SPECIFICATION

(11) **EP 0 207 801 B1**
(45) Date of publication and mention of the grant of the patent: **04.05.1994**
(21) Application number: 86305184.3
(22) Date of filing: 03.07.1986
(51) Int. Cl.: H01J 37/34

(54) **Cathode/ground shield arrangement in a target for a sputter coating apparatus**
Kathoden- und Erdschirmvorrichtung in einem Target für ein Beschichtungsgerät durch Zerstäubung
Dispositif de cathode et de blindage mis à la terre dans une cible pour appareil de dépôt par pulvérisation

(30) Priority: 05.07.1985 US 751914
(43) Date of publication of application: 07.01.1987
(73) Proprietor: WESTINGHOUSE ELECTRIC CORPORATION, Pittsburgh Pennsylvania 15235 (US)
(72) Inventor: Glasser, Albert Daniel, Columbia South Carolina 29210 (US)
(74) Representative: van Berlyn, Ronald Gilbert

(56) References cited:
- EP-A- 0 070 982
- EP-A- 0 107 510
- US-A- 4 391 697

## Description

The present invention relates generally to apparatus for depositing coatings on substrates and, more particularly, to a cathode/ground shield arrangement in a target of a sputter coating apparatus.

One field of use of sputter coating apparatus resides in the processing of nuclear fuel pellets. As well known in the nuclear reactor art, nuclear fuel pellets, commonly in the form of right circular cylinders, contain fissile material, such as uranium dioxide, thorium dioxide, plutonium dioxide or mixtures thereof. A stack of such pellets placed end-to-end within a cladding tube (typically made of a zirconium alloy or stainless steel) constitute a fuel rod; an array of such fuel rods grouped together forms a fuel assembly; and a plurality of such fuel assemblies grouped together forms the core of a nuclear reactor.

Likewise as well known, the life of a nuclear fuel assembly can be extended by combining an initially larger amount of fissile material with a calculated smaller amount of a burnable neutron absorber, also known in the art as a burnable poison. Burnable neutron absorbers are materials, such as boron, gadolinium, samarium, europium, and the like, which have a high probability (or cross-section) for absorbing neutrons and which, in absorbing neutrons, result in isotopes of sufficiently low neutron capture cross-section to be virtually transparent to neutrons, all while producing no new or additional neutrons. Burnable absorbers thus compensate for the larger amount of fissile material during the early life of the fuel assembly and, during reactor operation, are progressively reduced in amount. This results in a longer life at relatively constant fission level for the fuel assembly which, in turn, means less frequent fuel assembly replacements, or reactor refueling operations, which are costly and time-consuming.

In Applicant's U.S. patent specifications Nos. 4,587,088 and 4,560,462 there are disclosed a method and an apparatus, respectively, for sputter-depositing layers of burnable poisons on nuclear fuel pellets. Sputtering apparatus for depositing coatings on other kinds of products are disclosed in U.S. patent specifications No. 3,562,140, No. 3,632,494 and No. 4,080,281.

In a typical sputter process for depositing a coating on a substrate, such as a nuclear fuel pellet, an inert gas is introduced into a vacuum chamber containing an anode, the substrate, and a target cathode. A high voltage is applied across the anode and the target cathode. The gas molecules are ionized and strike the target cathode, thereby causing atoms and/or molecules of the latter to be sputtered from the surface thereof. The substrate is positioned to intercept this sputtered target material which upon striking the substrate, forms an adherent coating thereon. Sputtering is generally a line-of-sight coating process.

In the apparatus disclosed in Applicant's aforesaid U.S. patent specification No. 4,560,462, several targets are employed each of which includes a cathode with target material in the form of generally rectangular tiles of zirconium diboride disposed on an upper surface thereof. The cathode is usually made of copper with magnetic material disposed inside to concentrate electrons in the vicinity of the cathode. This concentration enhances the generation of argon ions which collide with the negatively charged target material on the top surface of the cathode. The remaining surfaces of the cathode must be protected from the argon ions in order to prevent sputtering of the material of the cathode itself. Therefore, these remaining cathode surfaces are shielded by means of a ground shield which is positively charged and, therefore, collects electrons while repelling the argon ions. The ground shield and the cathode are physically so arranged that a gap exists therebetween, the gap being wide enough to prevent electrical arcing thereacross yet small enough to prevent a plasma from starting because the electrons will have insufficient energy to ionize the argon.

This gap between the cathode and the ground shield is open at the top of the target and can, as recently discovered, give rise to a problem insofar as flakes of sputtered zirconium diboride emanating from a location above the target material will, on occasion, land across the gap and bridge it so as to short-circuit the oppositely charged ground shield and cathode. Such a short circuit will necessitate a temporary shut-down of the coating apparatus, thus causing significant expense and loss of time.

It is the principal object of the invention to overcome this problem, and the invention accordingly resides in a sputter-coating-apparatus target comprising an elongate cathode, sputter target material disposed on an outer surface of the cathode on one side thereof, and a ground shield having the cathode disposed therein and including walls surrounding the cathode, said ground shield enclosing the cathode on all sides thereof except said one side where the ground shield is open to leave said target material exposed, and said cathode and the ground shield being separated from each other by a gap defined therebetween, characterized by means in electrical contact with said sputter target material mounted on a peripheral edge portion of said outer surface of the cathode and forming a continuous peripheral ledge which extends laterally outward beyond said peripheral edge portion and overhangs said gap and the adjacent edges of said walls of the ground shield in spaced relationship therewith, whereby said gap (96) opens outwardly sideways relative to the cathode surface having said sputter target material disposed thereon.

With this arrangement, the gap between the cathode and the ground shield opens sideways relative to the cathode surface having the sputter target material thereon, its opening being shielded from loose flakes of sputtered material by the overhanging ledge. Thus, flakes of sputtered material falling upon the target cannot reach and bridge the gap but rather land harmlessly on the cathode and/or the overhanging ledge where they will stick, either to be resputtered or eventually to fall to the floor of the facility.

A preferred embodiment of the invention will now be described, by way of example only, with reference to the accompanying drawings, in which:-
Figure 1 is a schematic view of a sputter coating apparatus;
Fig. 2 is a schematic view showing the sputter coating apparatus with its drum withdrawn from the sputter chamber;
Fig. 3 is a fragmentary perspective front view of a lower portion of the open chamber of the apparatus, as seen when looking into the drum and showing two stationary lower targets of the earlier design mentioned hereinbefore;
Fig. 4 is a perspective rear view of the drum, showing stationary upper targets of said earlier design;
Fig. 5 is a schematic sectional view taken along line 5-5 of Fig. 1 and showing pellet-containing pallets on the drum together with stationary lower and upper targets;
Fig. 6 is a top, plan, detail view, with portions broken away, of one of the pallets shown in Fig. 5;
Fig. 7 is an enlarged top plan view of one of the stationary targets shown in Figs. 3 and 4;
Fig. 8 is a vertical longitudinal sectional view taken along line 8-8 of Fig. 7;
Fig. 9 is a fragmentary top plan view of a stationary target embodying the present invention;
Fig. 10 is a fragmentary side elevational view as seen along the line 10-10 of Fig. 9;
Fig. 11 is a top plan view of the ground shield of the target of Figs. 9 and 10 but shown on a smaller scale; and
Fig. 12 is a vertical longitudinal sectional view of the ground shield, as taken along line 12-12 of Fig. 11.

In the following description, like reference characters designate like or corresponding parts throughout the several views of the drawings, and terms such as "forward", "rearward", "left", "right", "upwardly", "downwardly" and the like are employed as words of convenience not to be construed as limiting terms.

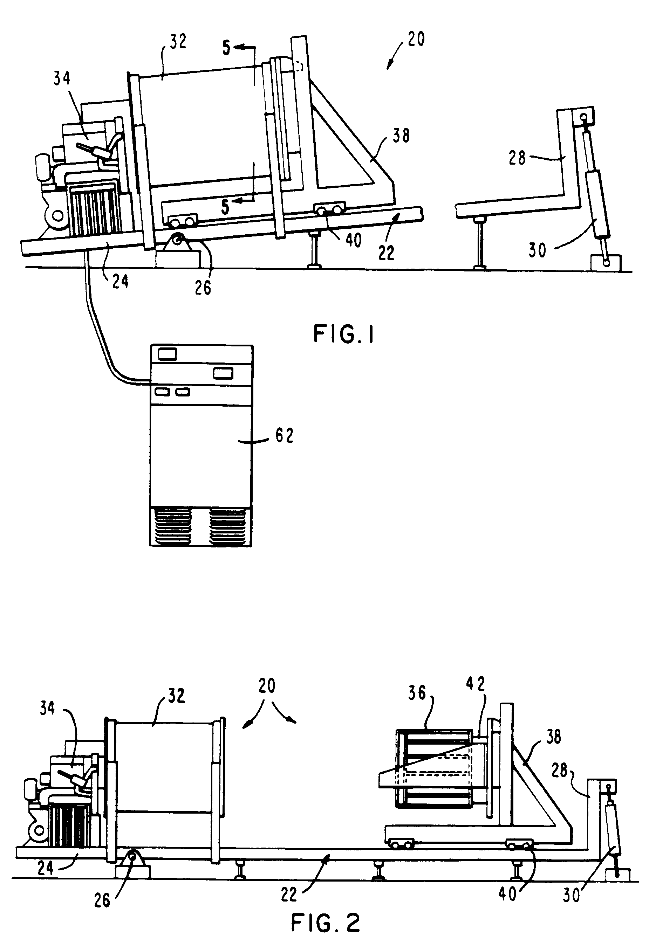

Referring to the drawings, and particularly to Fig. 1 thereof, the sputter coating apparatus illustrated therein and generally designated with reference numeral 20 is substantially the same as described and illustrated in Applicant's above-mentioned U.S. patent specification No. 4,560,462. It will be described herein but briefly in order to facilitate a complete understanding of the present invention.

Basically, the sputter coating apparatus 20 includes a frame 22 which is pivotally mounted near one end 24 on a hinge 26 and is supported at spaced locations along its longitudinal extent and at an opposite end 28 by a plurality of extendible and retractable cylinders 30. The apparatus 20 includes further a sputtering chamber 32 and a sputter machine 34 operatively associated therewith, both being stationarily mounted on the frame 22 at its one end 24.

In addition, the apparatus 20 includes a drum 36 mounted on a support carriage 38 having rollers 40 to facilitate fore-and-aft movement of the drum 36 toward and away from the stationary sputtering chamber 32 between the positions shown in Figs. 1 and 2. Movement of the carriage 38 together with the drum 36 is caused by tilting the frame 22 about the hinge 26 through actuation of the cylinder 30 connected to the end 28 of the frame opposite from the hinge 26. The drum 36 is mounted on the carriage 38 also for rotation about its longitudinal axis. A motor 42 likewise supported on the carriage 38 is coupled to the drum 36 and is operable to rotate same. The drum 36, when inserted in the sputtering chamber 32 (see Fig. 1), forms therewith a hermetic seal.

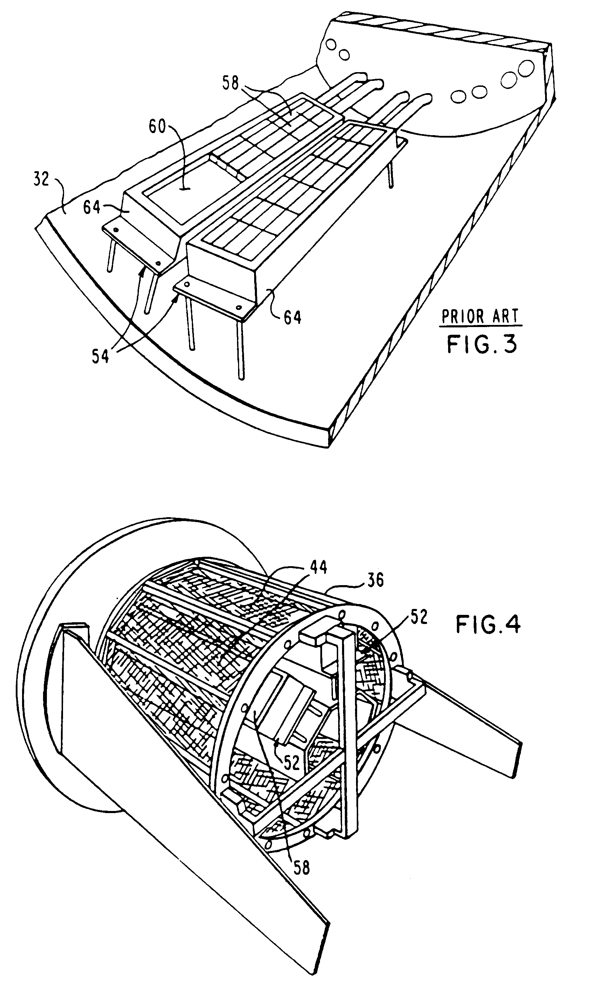

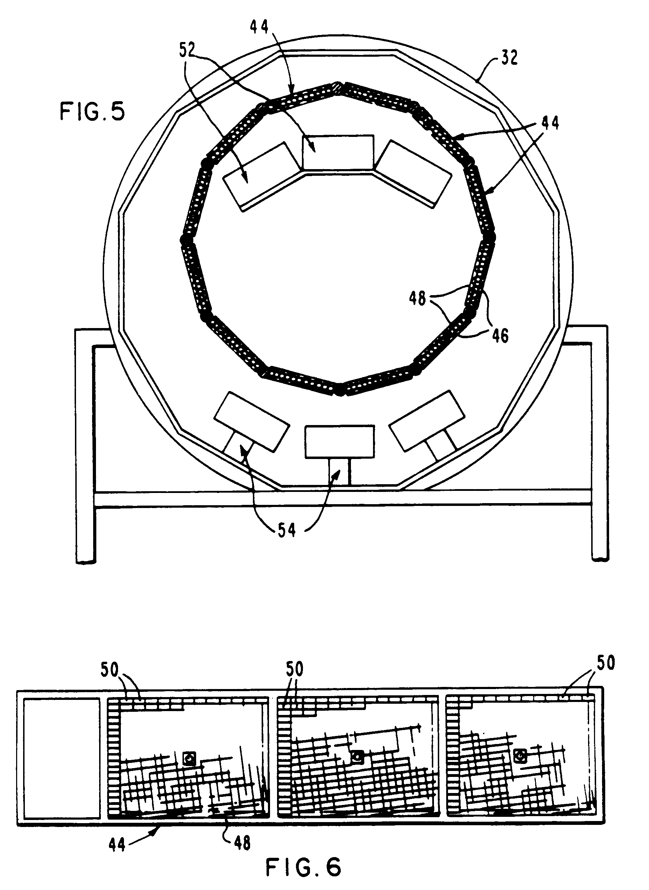

About the circumference of the drum 36 there are mounted several detachable pallets 44 (Figs. 4 and 5) each of which comprises lower and upper screened parts 46,48 and contains a single layer of nuclear fuel pellets 50 to be coated, the pellets preferably being aligned end-to-end in columns and rows (see Fig. 6). The sputter machine 34 has stationary upper and lower targets 52,54 mounted within the sputtering chamber 32, as seen in Figs. 3 to 5. Each of the targets 52,54 includes a cathode 56 with a number of target tiles 58 disposed on an upper surface 60 thereof. The material of the tiles 58, preferably zirconium diboride, is sputtered as a coating onto the nuclear fuel pellets 50 as the pallets 44 containing the latter are rotated together with the drum 36. A control console 62 is used to control the drum motor 42 and the sputter machine 34. The drum 36 is made an anode for the sputter machine.

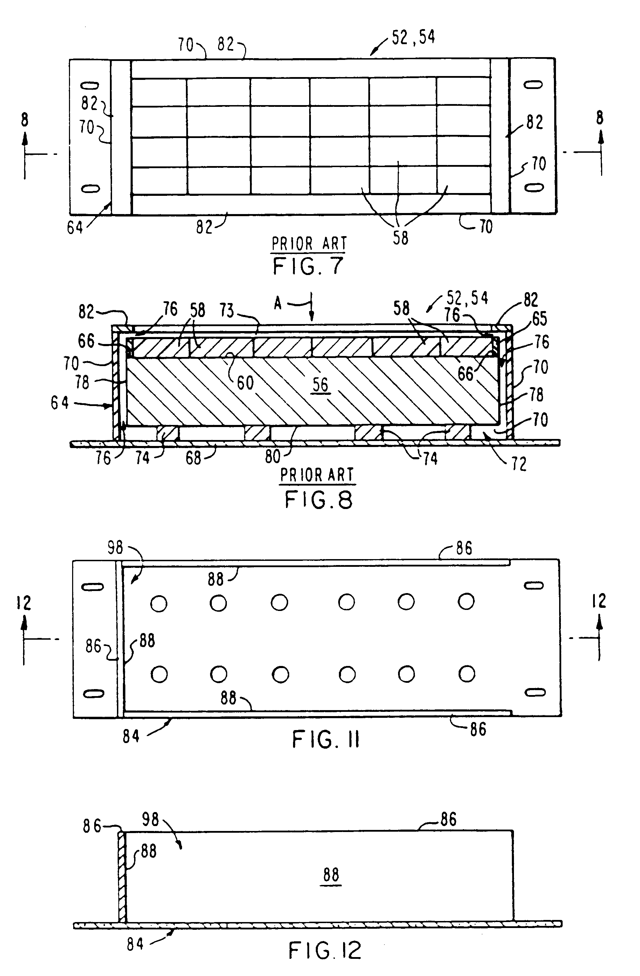

Turning to Figs. 7 and 8 which show the construction of one of the targets 52,54 previously utilized in the sputter coating apparatus 20, it is seen therefrom that each of these targets basically comprises a cathode 56, a plurality of target tiles 58, and a ground shield 64. The cathode 56 is of elongate, generally rectangular shape and is made of an electrically conductive material. The target tiles 58, formed of sputter frangible material, such as zirconium diboride, are disposed on the upper surface 60 of the cathode as a layer retained in position by a retainer 65 mounted on an upper peripheral edge portion 66 of the cathode 56 and extending around the layer of target titles 58.

The ground shield 64 is made of an electrically conductive material and is of box-like construction including a bottom wall 68 and sidewalls 70 which define a hollow cavity 72 with an open top 73. The interior dimensions of the cavity 72 are somewhat greater than the exterior dimensions of the cathode 56 such that, when the cathode is placed into the cavity and is supported therein, e.g. by means of insulative blocks 74 on the bottom wall 68 of the ground shield 64, the cathode 56 will be separated and electrically isolated from the ground shield by a gap 76 defined between the cathode 56 and the bottom and sidewalls 68,70 of the ground shield 64. The ground shield 64, with the cathode 56 thus disposed therein, encloses the latter on all sides 78 and at the bottom 80 thereof but, as its open top 73, leaves the layer of target tiles 58 exposed. In other words, all surfaces of the cathode except the layer of target tiles 58 on the upper cathode surface 60 are protected from being bombarded and sputtered by argon ions.

As seen from Figs. 7 and 8, the side walls 70 of the ground shield 64 in this earlier target construction have upper, inwardly directed flanges 82 which extend around the cathode 56 in spaced overlying relationship with the retainer 65 thereon such that the gap 76 between the ground shield 64 and the cathode 56 is open towards and accessible from a direction directly facing the open top 73 of the ground shield 64, as indicated by an arrow A in Fig. 8. This is the direction in which flakes of zirconium diboride would fall onto the cathode 56 from a location above the targets 52,54. Since the upper flanges 82 of the ground shield 64 and the target tiles 58 and/or upper peripheral retainer 65 on the cathode 56 are oppositely charged, a flake falling onto the target and bridging the gap 76 by contacting both the flange 82 and the retainer 65 and/or target tiles 58 will short-circuit the cathode and the ground shield.

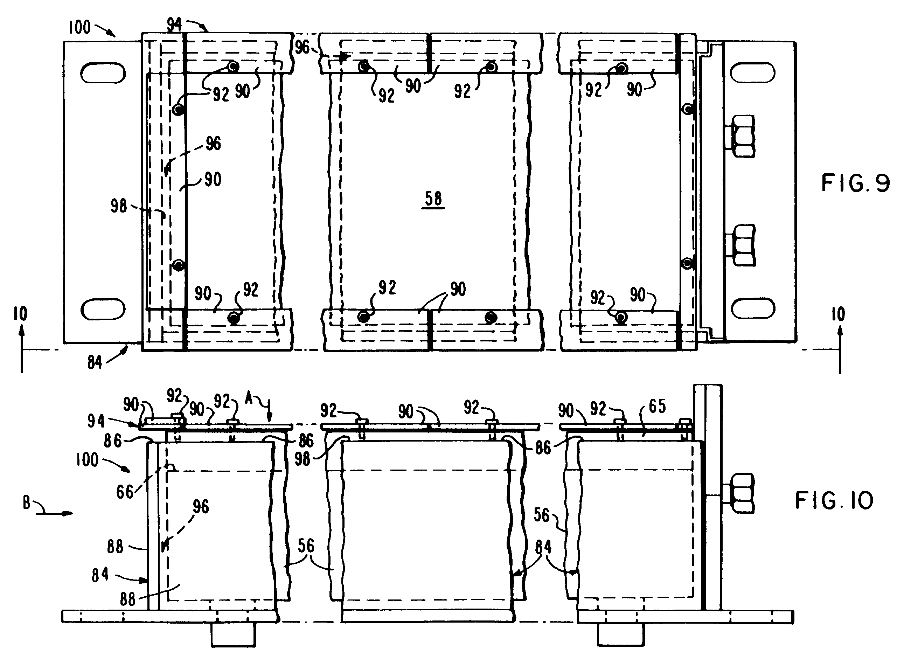

Referring now to Figs. 9 to 12, there is shown a target 100 with an improved cathode/ground shield arrangement according to the invention. The ground shield 84 is similar to the ground shield 64 described above, except that the upper edges 86 of the sidewalls 88 of the ground shield 84 are displaced slightly below the upper peripheral edge of the target comprising the cathode 56 together with the target tiles 58 and the retainer 65 thereon.

In addition, means in the form of peripheral strips 90 mounted on the retainer 65 and, through the latter, on the peripheral edge portion 66 of the cathode surface 60 are provided to form a continuous peripheral ledge 94 which extends laterally outward beyond the edge portion 66 of the cathode surface so as to overhang the gap 96 and the adjacent upper edges 86 of the sidewalls 88 of the ground shield 84 in spaced relationship therewith. The strips 90 are shown connected to the retainer 65 by means of fasteners 92.

With this arrangement, the strips 90 cover exposure of the gap 96 from the direction A directly facing the open top 98 of the ground shield 84 and they relocate exposure of the gap 96 to a direction B (Fig. 10) angularly displaced from direction A and facing the sidewalls 88 of the ground shield 84. Thus, falling flakes of zirconium diboride will no longer be able to bridge the gap 96 between the cathode 56 (or the strips 90 which are electrically conductive and of the same polarity as the cathode) and the ground shield 84 since this gap opens at the lateral sides of the target 100.

## Claims

1. A sputter-coating-apparatus target comprising an elongate cathode, sputter target material disposed on an outer surface of the cathode on one side thereof, and a ground shield having the cathode disposed therein and including walls which surround the cathode, said ground shield enclosing the cathode on all sides thereof except said one side where the ground shield is open so as to leave said target material exposed, and said cathode and the ground shield being separated and electrically isolated from each other by by a gap defined therebetween, characterized by means (90) in electrical contact with said sputter target material mounted on a peripheral edge portion (66) of said outer surface (60) of the cathode (56) and forming a continuous peripheral ledge (94) which extends laterally outward beyond said peripheral edge portion (66) and overhangs said gap (96) and the adjacent edges (86) of said walls (88) of the ground shield (84) in spaced relationship therewith, whereby said gap (96) opens outwardly sideways relative to the cathode surface having said sputter target material disposed thereon.

2. A sputter-coating-apparatus target according to claim 1, characterized in that said means (90) forming said ledge (94) comprises an arrangement of strips extending peripherally about said outer surface (60) of the cathode (56) above said peripheral edge portion (66) thereof.

3. A sputter-coating-apparatus target according to claim 2, characterized in that said sputter target material (58) has associated therewith a retainer (65) which surrounds the sputter target material and is supported on said peripheral edge portion (66) of said outer surface (60) of the cathode (56), said strips (90) being fastened to said retainer (65) and extending laterally therefrom to form said ledge (94).

## Patentansprüche

1. Target für ein Beschichtungsgerät durch Zerstäubung, das eine langgestreckte Kathode umfasst, Zerstäubungstargetmaterial, das auf einer äusseren Oberfläche einer Seite der Kathode angeordnet ist, und einen Erdschirm, der die Kathode darin angeordnet hat und Wände einschliesst, die die Kathode umgeben, wobei der Erdschirm die Kathode auf allen Seiten einschliesst, ausser der einen Seite, wo der Erdschirm offen ist, um das Targetmaterial blossgestellt zu lassen, und wobei die Kathode und der Erdschirm getrennt sind und voneinander mittels eines zwischen ihnen definierten Spaltes elektrisch isoliert sind, gekennzeichnet durch ein Mittel (90) in elektrischem Kontakt mit dem Zerstäubungstargetmaterial, das auf einem umgebenden Randteil (66) der äusseren Oberfläche (60) der Kathode (56) angeordnet ist, und eine kontinuierliche periphere Leiste (94) bildet, die sich seitlich nach aussen über den peripheren Randteil (66) erstreckt, und über dem Spalt (96) und den benachbarten Rändern (86) der Wände (88) des Erdschirms (84) in beabstandetem Verhältnis dazu hängt, wobei der Spalt (96) sich seitlich nach aussen relativ zur Kathodenoberfläche, die das Zerstäubungstargetmaterial darauf angeordnet hat, öffnet.

2. Target für ein Beschichtungsgerät durch Zerstäubung nach Anspruch 1, dadurch gekennzeichnet, dass das Mittel (90), das die Leiste (94) bildet, eine Anordnung von Streifen umfasst, die sich peripher um die äussere Oberfläche (60) der Kathode (56) über ihren peripheren Randteil (66) erstrecken.

3. Target für ein Beschichtungsgerät durch Zerstäubung nach Anspruch 2, dadurch gekennzeichnet, dass dem Zerstäubungstargetmaterial (58) eine Rückhaltevorrichtung (65) zugeordnet ist, die das Zerstäubungstargetmaterial umgibt, und auf dem peripheren Randteil (66) der äusseren Oberfläche (60) der Kathode (56) unterstützt wird, wobei die Streifen (90) an der Rückhaltevorrichtung (65) befestigt sind, und sich seitlich davon erstrecken, um die Leiste (94) zu bilden.

## Revendications

1. Cible pour appareil de revêtement par pulvérisation qui comprend une cathode allongée, un matériau de cible de pulvérisation placé sur une surface extérieure d'un côté de la cathode et un blindage mis à la masse dans lequel est disposée la cathode et qui comprend des parois entourant la cathode, ledit blindage mis à la masse erfermant la cathode sur tous les côtés à l'exception dudit côté où le blindage mis à la masse est ouvert pour laisser à nu ledit matériau cible, ladite cathode et ledit blindage mis à la masse étant séparés et électriquement isolés l'un de l'autre grâce à un intervalle défini entre eux, caractérisé par un moyen (90) en contact électrique avec ledit matériau de cible de pulvérisation, monté sur une partie marginale périphérique (66) de ladite surface extérieure (60) de la cathode (56) et formant un rebord périphérique continu (94) qui s'étend latéralement vers l'extérieur, au-delà de ladite partie marginale périphérique (66), et qui surplombe ledit intervalle (96) et les bords adjacents (86) desdites parois (88) du blindage mis à la masse (84) en en étant espacé, ce qui fait que ledit intervalle (96) s'ouvre vers l'extérieur, sur les côtés par rapport à la surface de la cathode sur laquelle est placé ledit matériau de cible de pulvérisation.

2. Cible pour appareil de revêtement par pulvérisation selon la revendication 1, caractérisé en ce que ledit moyen (90) qui forme ledit rebord (94) comprend un agencement de bandes qui s'étendent de façon périphérique autour de ladite surface extérieure (60) de la cathode (56), au-dessus de ladite partie marginale périphérique (66) de celle-ci.

3. Cible pour appareil de revêtement par pulvérisation selon la revendication 2, caractérisé en ce que ledit matériau (58) de cible de pulvérisation a un dispositif de retenue (65) qui lui est associé, entourant le matériau de cible de pulvérisation, et est supporté sur ladite partie marginale périphérique (66) de ladite surface extérieure (60) de la cathode (56), lesdites bandes (90) étant fixées audit dispositif de retenue (65) et s'étendant latéralement depuis celui-ci pour former ledit rebord (94).
